Europäisches Patentamt

(19) European Patent Office

Office européen des brevets

(11) Publication number: **0 236 730 B1**

(12) **EUROPEAN PATENT SPECIFICATION**

(45) Date of publication of patent specification :
04.12.91 Bulletin 91/49

(51) Int. Cl.⁵ : **B26F 3/00, G03F 7/16**

(21) Application number : 87101475.9

(22) Date of filing : 04.02.87

(54) **Film peeling apparatus with a sliding press element.**

(30) Priority : 05.02.86 JP 23178/86

(43) Date of publication of application :
16.09.87 Bulletin 87/38

(45) Publication of the grant of the patent :
04.12.91 Bulletin 91/49

(84) Designated Contracting States :
AT BE CH DE FR GB IT LI NL SE

(56) References cited :
EP-A- 0 142 880
DE-A- 3 402 009
DE-B- 1 231 261
DE-B- 1 232 875
JP-A-58 091 782

(56) References cited :
US-A- 3 669 445
PATENT ABSTRACTS OF JAPAN, vol. 9, no. 6
(P-326)[1729], 11th January 1985; & JP-A-59
154 447 (HITACHI KASEI KOGYO K.K.) 03-
09-1984

(73) Proprietor : SOMAR CORPORATION
11-2, Ginza 4-chome Chuo-ku
Tokyo 104 (JP)

(72) Inventor : Sumi, Sigeo
8-11, Ayase
Hasuda-shi Saitama (JP)

(74) Representative : Boeters, Hans Dietrich, Dr. et
al
Boeters & Bauer Bereiteranger 15
W-8000 München 90 (DE)

## Description

This invention relates to a film raising device as defined in the first part of claim 1.

Such panel may be that one of a printed circuit board for use in electronic equipment as e.g. computers. Such printed circuit board is provided with a predetermined copper wiring pattern formed on one or both sides of an insulating substrate. A printed circuit board of that sort is manufactured substantially by the following steps:

Laminating a combination of a photosensitive resin layer (photo-resist) and a translucent resin film (protective film) for protecting the photosensitive resin layer onto a conductive layer on an insulating substrate through thermocompression bonding, superposing a film having a wiring pattern, exposing the photosensitive resin layer for a fixed period of time to light inciding through the film having the wiring pattern and the translucent resin film, developing the thus exposed photosensitive resin layer after peeling off the translucent resin film to form an etching mask pattern, removing the unnecessary portions of the conductive layer by etching, and, finally, removing the remaining photosensitive resin layer.

As mentioned before, during the manufacture of a printed circuit board, the translucent resin film must be peeled off when the photosensitive resin layer is to be developed after having been exposed to light. To perform this task mechanically, devices have already been proposed employing an adhesive tape which is stuck to the translucent resin film for peeling off (see e.g. JP-A-58 091 782). Other devices are known which employ suction means to strip a protective layer from a base.

DE-A1-27 51 862 comprises the features of the first part of claim 1. This apparatus has two consecutive rubbing devices followed by a stripping unit to peel off a protective resin film in the production of printed circuit boards.

Still, there is a need to further develop such apparatus. Accordingly, the invention as claimed is intended to provide such apparatus which is capable of reliably peeling off a protective film, such as a translucent resin film, from a base or pane as e.g. in the manufacture of a printed circuit board and more particularly the invention aims at creating a film raising device of the character as mentioned above in order to initiate and facilitate a succedent peeling operation.

The film raising device as defined in claim 1, though simple in construction, is effective in raising a leading end portion of the film that is subsequently to be peeled off from the panel as e.g. in the manufacture of a printed circuit board. When the support shaft of the film raising device is rotated, the pointed end of the biased press member slides along the surface of the panel while being pressed against this surface. In the course of this sliding motion it will hit the film and distort it whereby the respective portion of the film will be loosened from the underground. In the case of manufature of a printed circuit board, where the underground is in the form of a panel having a photosensitive resin layer on top of a conductive layer, the photosensitive resin layer is usually prepared from a material softer than that of the protective translucent resin film to be peeled off. Therefore the photosensitive resin layer will endure a plastic deformation by the pressure applied through the translucent resin film, this deformation additionally facilitating loosening of the resin film.

An element somewhat similar to the biased press member of the present invention is disclosed in DE-A1-34 02 009 in the form of a scraper that is vibratorily driven in its longitudinal direction. In this case two such scrapers are provided side by side in a hand-held tool designed for removing paint, wall paper, tar paper or plaster. None of the scrapers of this tool is subject to a rotary motion or mounted in a defined distance from the respective underground.

The dependent claims describe additional means or measures which assist in achieving the above mentioned object.

In the following preferred embodiments of a film raising device according to the invention as well as a film peeling apparatus employing such film raising device are described taking reference to the accompanying drawings.

## BRIEF DESCRIPTION OF THE DRAWINGS

In the accompanying drawings:

Fig.1 is a sectional view showing the construction of a press device forming part of a film raising device according to a first embodiment of the present invention;

Fig. 2 is a sectional view showing the construction of a press device in an alternative embodiment of the present invention;

Fig. 3 is a perspective view of the press device of Fig. 2 along with a support shaft thereof;

Fig. 4 is a schematic side view showing the principal construction of a total film peeling apparatus to which a film raising device of the present invention is applied;

Fig. 5 is an enlarged side view of the principal portion of Fig. 4;

Fig. 6 is a side view showing drive means employed in a film raising device according to the present invention;

Fig. 7 is an exploded view of the drive means shown in Fig. 6;

Figs. 8 and 9 are schematic sectional views showing different phases in the operation of a film raising device in accordance with the present invention;

Fig. 10 is a perspective view of another item in a film peeling apparatus as shown in Figs. 4 and 5;

Fig. 11 is an expanded exploded perspective view of the principal parts of a film conveying mechanism employed in the apparatus of Figs. 4 and 5;

Figs. 12 is a sectional view showing a detail of the film conveying mechanism of Fig. 11;

Fig. 13 is a sectional view showing the construction of a press device forming part of a film raising device according to a third embodiment of the present invention;

Fig. 14 is a plan and partially cross sectional view of the press device of Fig. 13, along the line XIV - XIV;

Fig. 15 is plan view showing the construction of finger portions of the press device of Fig. 13;

Fig. 16 is a perspective view of the press device of Fig. 13; and

Fig. 17 is a perspective view showing a detail of the press device of Fig. 13.

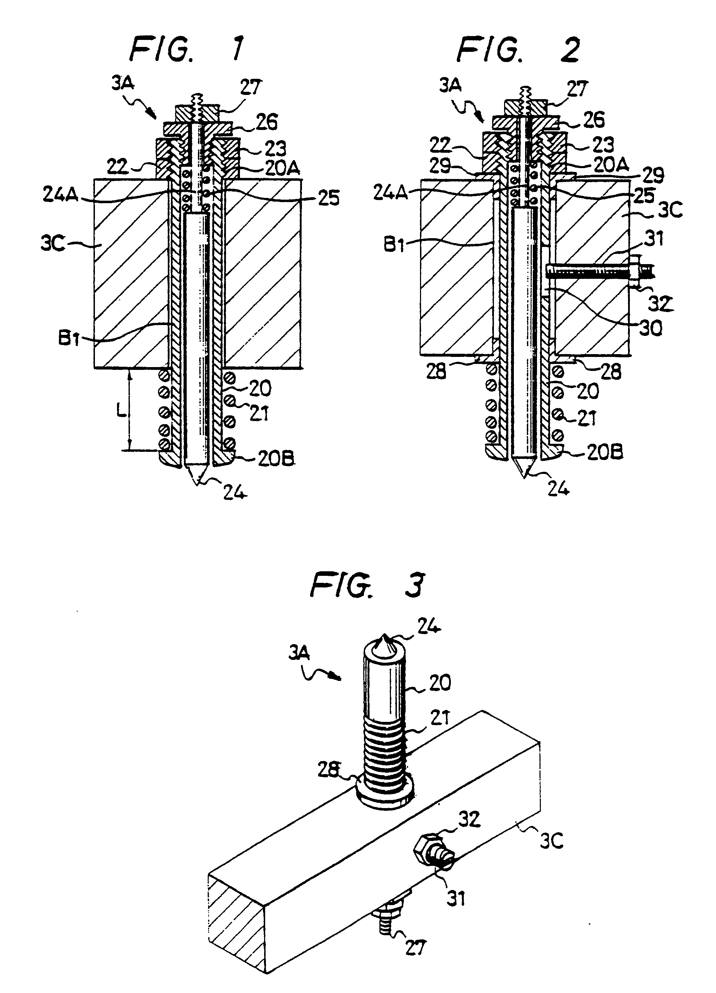

The press device 3A shown in Fig. 1 comprises a substantially cylindrical support member 20 having, at its one end, a head 20B and, at its other end, a thread 20A. A first spring 21 is arranged along the outer peripheral surface of the support member 20 and the support member 20 with the spring 21 thus arranged is inserted into a through-hole B1 provided in a rotatable support shaft 3C with the head 20B directed outwardly. Subsequently, a position adjustment nut 22 is screwed onto the thread 20A, so that the support member 20 is slidable in the through-hole B1 by a limited distance. Then a lock nut 23 is also screwed onto the thread 20A to fix the nut 22 in any selected position thereof.

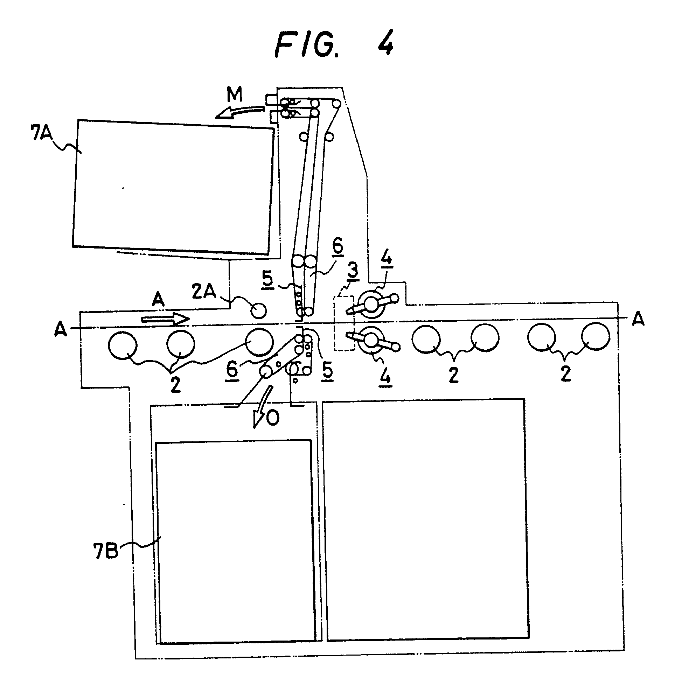

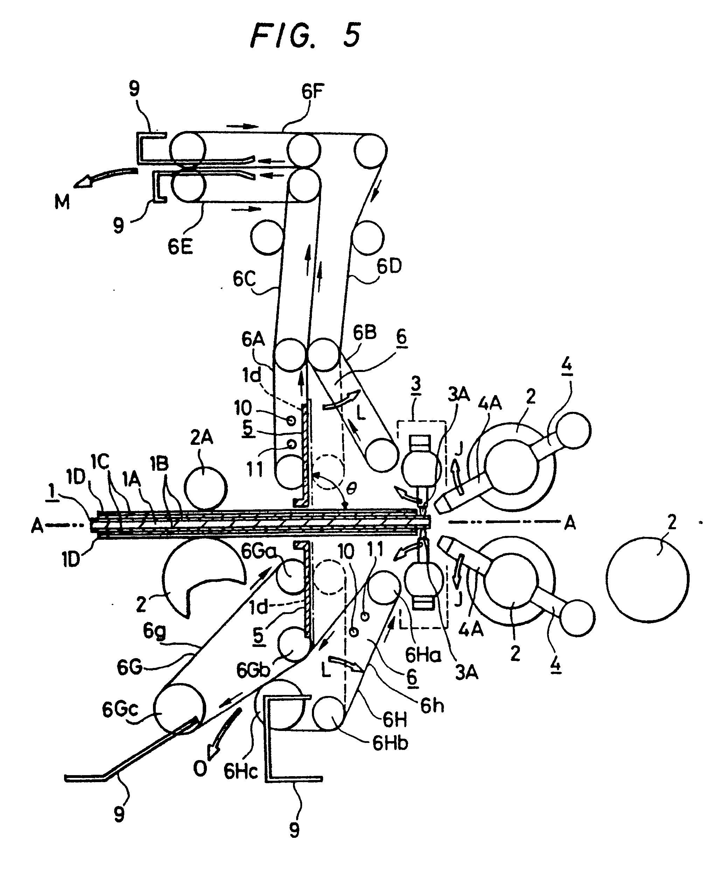

The spring 21 is employed to press the support member 20 against the film bearing underground such as a panel, 1 as shown in Figs. 5,8 and 9. The outward face of the head 20B is rounded, so that it has excellent sliding properties. Therefore, the support member 20 can slide on the panel, when the head 20B thereof contacts the panel. Accordingly a photosensitive resin layer or the like (1C/Figs. 5,8 and 9) on the panel is prevented from being damaged by the support member 20. Additionally, other devices such as a fluid injection device (4/Figs. 4 and 5) may be used to minimize friction. The position adjustment nut 22 allows to adjust the distance L between the head 20B and the support shaft 3C.

A press member 24 is slidably inserted in the support member 20. A second spring 25 is fitted on a thin extension 24A of the press member 24. The extension 24A is inserted in the hole of an eyelet nut 26 which is removably screwed into the support member 20. An additional nut 27 is threaded to the top of the extension 24A.

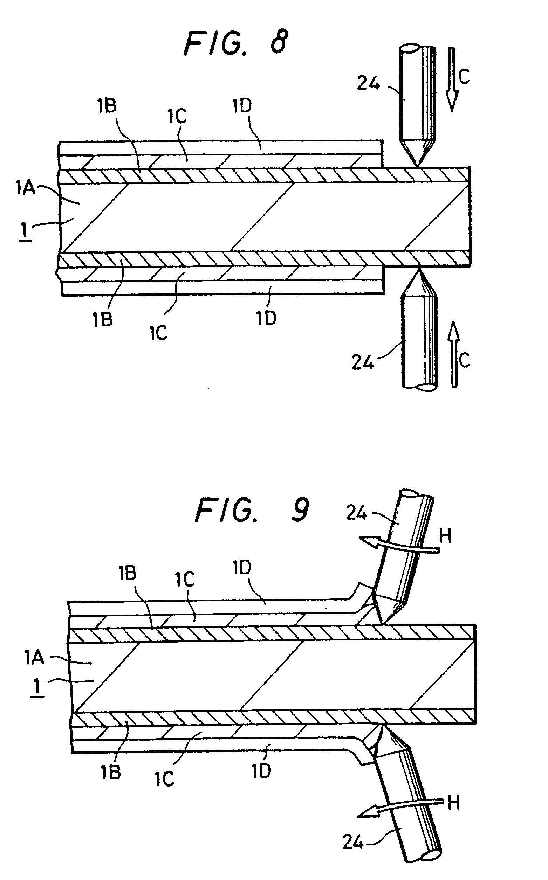

The spring 25 is used to press the tip of the press member 24 to the panel 1 (comp. Figs. 8 and 9). The press member 24 is adjusted by the nut 27 such that its tip projects a little outside of the support member 20. As shown, this tip forms a cone, its cone angle preferably being about 60 degrees.

The eyelet nut 26 is used to adjust the projection length of the press member 24 with regard to the face of the head 20B whereas the nut 27 is used to further adjust the projection length of the press member 24 and, additionally, to adjust the strength of the spring 25 for pressing the press member 24 outwardly. The projection length of the press member 24 from the face of the head 20B is preferably adjusted to about 0.5 mm.

Operation of the press device so far described is as follows:

In order to peel a film from both sides of a panel such as panel 1 in Figs. 8 and 9, the support shafts 3C on both sides of the panel are moved towards each other, so that the press members 24 supported by the support shafts 3C are pressed against the surface of the panel in the vicinity of the leading end of the film 1D. Then the support shafts 3C are rotated to effect that the film end portions are raised from the panel for peeling in a subsequent peeling station. When the support shafts 3C are rotated, the tips of the press members 24 and the heads 20B of the support members 20 move horizontally along the panel surface, pressing against this surface irrespective of the thickness of the panel, this being due to the springs 21 and 25 and adjustment by the nuts 22,26 and 27.

Since in the panel there may be a positioning hole having a diameter of 1 to 3 mm the support member 20 or, respectively, its head 20B preferably has a diameter larger than the diameter of the hole. Furthermore, the conus angle at the tip of the press member 24 of about 60 degrees, and the projection length of the press member 24 of about 0,5 mm from the face of the head 20B assist the press member to avoid or, respectively, escape the hole. If the press member 24 has entered the hole it can slip out thereof again by the rotation of the support shaft 3C. That is, the support member 20 also acts as a stopper for preventing the press member 24 from failing too deeply into the hole.

Fig. 2 shows a variation of the construction of a press device 3A. Fig.3 is an external view of the press device 3A of Fig. 2 together with its support shaft 3C.

Since the press device 3A of the Figs. 2 and 3 has eyelet sliding members 28 and 29 inserted between the support member 20 and the hole B1 of the support shaft 3C the support member 20 can slide in the hole B1 more easily.

Further, a suitable hole 30 is provided in the side of the support member 20 and the support shaft 3C is provided with a screw member 31 to fit into the hole 30. Thus, the support member 20 is prevented from rotating with respect to the support shaft 3C. The screw member 31 also prevents the press device 3A from falling down when the position adjustment nut 22 is removed from the support member 20.

Naturally, the width of the hole 30 is selected so that the support member 20 can slide up and down in the hole B1. A lock nut 32 is fixed to the member 31 to prevent it from loosening.

Fig. 4 is a schematic side view showing the construction of a film peeling apparatus to which two film raising devices of the present invention are applied. Fig. 5 is an enlarged side view of the principal portion of Fig. 4.

The film peeling apparatus shown in Figs. 4 and 5 includes a conveying mechanism mainly comprising conveying rollers 2 for conveying panels 1, as shown in Fig. 5. Along this conveying mechanism, i.e. path A-A, press mechanism 3, a fluid injection mechanism 4, a peeling plate 5 and a film delivery mechanism 6 are arranged .

On the panels 1 a conductive layer 1B of copper or the like is formed on one or, as shown, both sides of an insulating substrate 1A (Fig. 5). A laminate consisting of a photosensitive resin layer 1C and a protective film 1D in the form of a translucent resin film is thermally bonded onto the conductive layer 1B under pressure. The photosensitive resin layer 1C has been exposed to light in a predetermined circuit pattern. The conveying rollers 2 convey the panels 1 in the direction of the arrow A, as shown in Fig. 4.

The press mechanism 3 comprises a plurality of press devices 3A installed on both sides of the path of the panels 1. The press devices 3A are arranged in a direction transversal to the conveying direction of the panels.

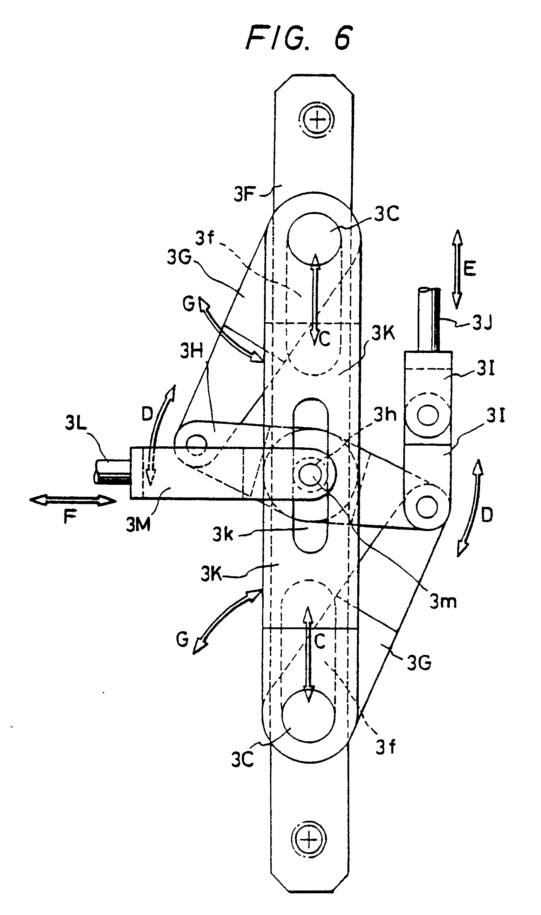

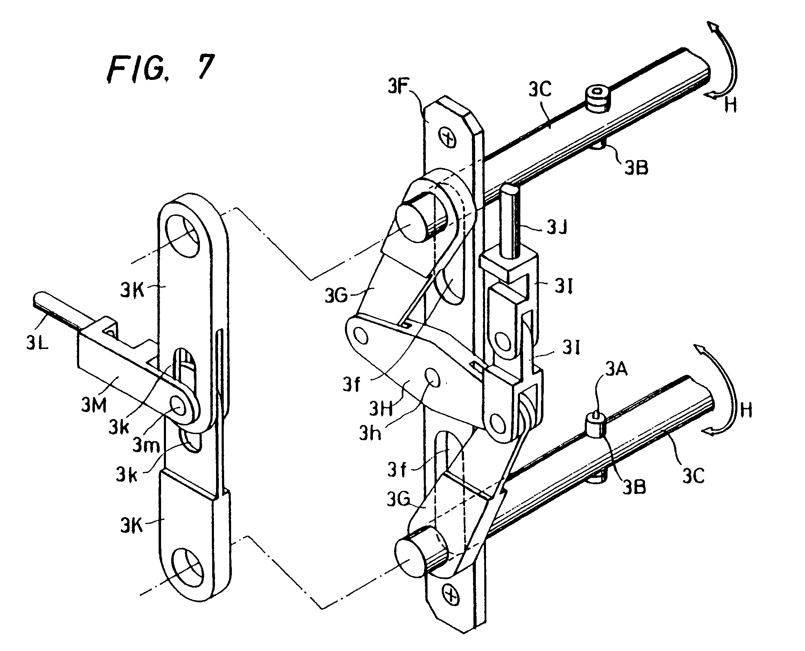

One end (or both ends) of the support shaft 3C is, as shown in Figs. 6 and 7 rotatably coupled to one end of an arm 3G through a guide slit 3f made in a guide member 3F which is fixed to the apparatus body with machine screws or the like (not shown). The guide slit 3f is formed in the direction of arrow C, i.e. vertical to the plane of the panels 1 so as to guide the support shaft 3C in the direction of the arrow C. The other end of each arm 3G is rotatably secured to one of the opposite ends of a double-armed lever 3H secured to a rotary shaft 3h to be itself rotary in the direction of arrow D. Thus, the double-armed lever 3H is capable of moving each support shaft 3C in the direction of arrow C.

At its one end the double-armed lever 3H is rotatably coupled to a link member 3I on a shaft 3J movable in the direction of arrow E. Movement of the shaft 3J is caused by a driving source such as a pneumatic or hydraulic cylinder, or a solenoid (not shown):

By thus coupling the press devices 3A at both sides of the panel 1 to the aforementioned driving source they can be caused to contact with or depart from the surface of the panel 1.

To rotate each of the support shafts 3C inclusive the press devices 3A, a is fixedly secured to an end (or both ends) of each support shaft 3C. At the other end of each rotating arm 3K, there is provided a slit 3K. The slit 3K receives a connection bolt 3m of a link member 3M connected by a shaft 3L to a driving source which may be formed by similar means as the aforementioned driving source for effecting movement of the support shafts 3C in the direction of the arrows C.

When the shaft 3L moves in the direction of arrow F, the rotating arms 3K rotate in the direction of the arrows G and, accordingly, the supporting shafts 3C rotate in the direction of the arrows H (Fig. 7). As a consequence the press devices 3A press the end of the panel 1 therebetween.

The rotation mechanism thus constructed is capable of operating the press devices 3A on both sides of the panel 1 with one driving source only and of controlling the operation quantity and time thereof accurately, as is the case with the previously described link mechanism for approaching and separating the press members 3A in the direction of the arrows C.

Referring now to Figs. 4 through 9, the operation of the press mechanism 3 so far described is as follows:

A thin film end detector, e.g. a touch sensor or a photosensor detects the end of the film to be peeled from a panel 1. In response thereto a pinch roller 2A as shown in Figs. 4 and 5 is pressed against the panel 1, and conveyance of the panel 1 is temporarily stopped. To effect precise stopping of the panel 1, the peripheral surface of the conveying roller 2 opposite to the pinch roller 2A may be coated with a high friction material such as rubber.

Then the shaft 3J is moved in the direction of arrow E (upward in Fig. 6) so that the support shafts 3C are caused to move in the direction of the arrows C. As a result, the outward ends of the press devices 3A on both sides of the panel 1 contact the surface of the conductive layer 1B at the end of the panel as shown in Fig. 8. That is, the tip of the press member 24 contacts the surface of the conductive layer 1B with a suitable pressing force as provided by the springs 25 and 21.

While the press devices 3A are thus in contact with the panel 1, the shaft 3L is moved in the direction of arrow F (to the left in the Fig. 6) effecting that the support shafts 3C rotate in the direction of the arrows H. Accordingly the ends of the press devices 3A press the end of the laminated bodies on both sides of the panel 1 as shown in Fig. 9, and this effects that a part of the translucent resin film 1D is raised from the photosensitive resin layer 1C and a gap is produced at the interface there between. The photosensitive resin layer 1C is prepared from a material softer than that of the translucent resin film 1D. Therefore, the layer 1C is apt to be subjected to plastic deformation by the pressure applied by the press members 24 in contrast to the film 1D. Therefore, at first only the layer 1C is deformed and, accordingly, adhesion of the film 1D to the layer 1C is reduced, before also the film 1D is deformed.

The end of the film 1D thus loosened from the layer 1C can then be peeled off by pointed press member 24 which is simple in configuration.

Of course the invention is not limited to the above described structure. E.g. the press mechanism 3 may have only one press device 3A on the respective sides of the panel 1. Alternatively, press devices 3A may be arranged at the end portion or portions close to the corner of the laminated body, in the conveying direction of the panels 1.

The press mechanism 3 may also be so constructed that the panels 1 are slightly carried on by rotation of the conveying roller 2 (or the pinch roller 2A) with the press devices 3A in contact with the surface of the panels.

As shown, the cross section of the support shaft 3C may be square, in order to ease accurate processing of the through-holes B1 into which the devices 3A are fitted.

As shown in Figs. 4 and 5, the fluid injection mechanism 4 is so arranged close to the press mechanism 3 as to send a jet of pressurized fluid such as air or inactive gas or liquid such as water out of a nozzle 4A directly into the gap between the photosensitive resin layer 1C and the lifted translucent resin film 1D. The angle of the nozzle 4A may be variable in the direction of arrow J to be able to direct the nozzle toward the gap between the layer 1C and the film 1D at the time of injecting the fluid, whereas, after the fluid has been injected, the fluid injection mechanism 4 may move the nozzle 4A back to a position where it is prevented from touching the panel 1.

By the fluid blown into the gap between the photosensitive resin layer 1C and the translucent resin film 1D produced under the pressure of the press member 24 the peeling of the film 1D is facilitated.

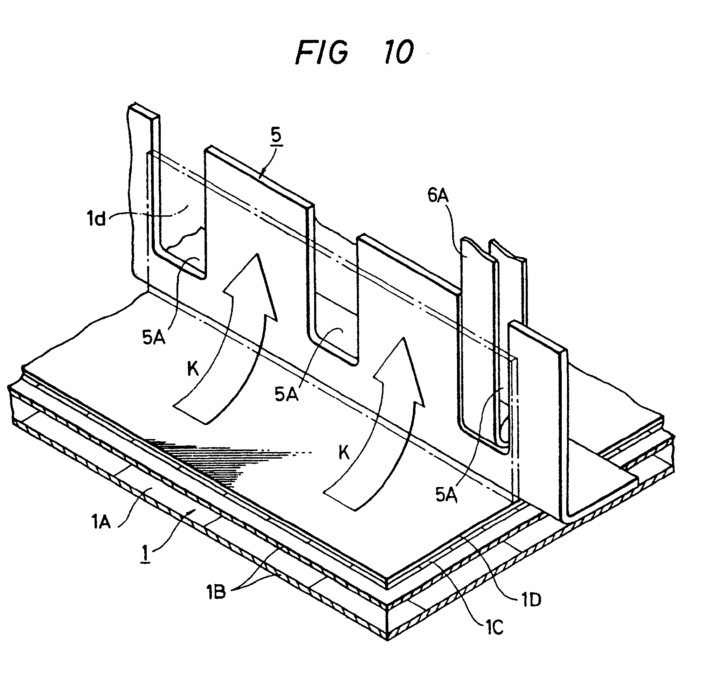

As shown in Figs. 5 and 10, the front end 1d of the translucent resin film 1D in the conveying direction which has so been peeled off hits peeling plate 5 under the influence of the fluid pressure. The peeling plate 5 is set to a desired peel angle θ which is the angle of the translucent resin film 1d pulled up with respect to the translucent resin film 1D still stuck to the panel 1.

The peeling plate 5 is installed such that its front end on the peeling side is apart from the translucent resin film 1D stuck to the panel 1 so that it may not brush the film 1D to prevent the photosensitive resin layer 1C from being damaged or broken. But the peeling plate 5 is arranged so that its end sticks tightly to the translucent resin film 1D during the time the fluid is blown into the gap, for preventing reduction of the peel effect, since the peel effect is reduced if the fluid is allowed to escape between the end of the peeling plate 5 and the panel 1. Moreover, the front end of the peeling plate 5 is bent in an arc from with a curvature radius less than 3 mm.

The peeling plate 5 is fixed to the apparatus body at a predetermined position apart from the nozzle 4A in the fluid flowing direction.

It has its front end located closer to the panels 1 than the film delivery mechanism 6 and extends in the film delivery direction with a predetermined length, and also transversally to the film delivery direction, its breadth being enough to cover the width of the conveying path of the panels 1 or the width of the fluid injection which is symbolized by the arrows K. The peeling plate 5 is able to increase the peeling effect by preventing the fluid from being blown past the film to be peeled. Further, it is able to stabilize the peeling position to apply a uniform peeling force to the film 1D and to prevent peel stress from distorting the photosensitive resin layer 1C.

The peel angle θ as defined by the peeling plate 5 with respect to the translucent resin film 1D may vary within the range of obtuse to right angle, depending on conditions such as the material of the film 1D, the fluid pressure in the fluid injection mechanism 4, etc. Further, the peeling plate 5 may be adjustable corresponding to the thickness of the panels 1, the photosensitive resin layer 1C or the film 1D. Adjustment of the peeling plate 5 may be effected by an air or hydraulic cylinder (not shown).

The peeled film 1d adhering to the peeling plate 5 is carried out of the apparatus by the film delivery mechanism 6, Figs.4, 5 and 11, with the same speed as it is peeled off.

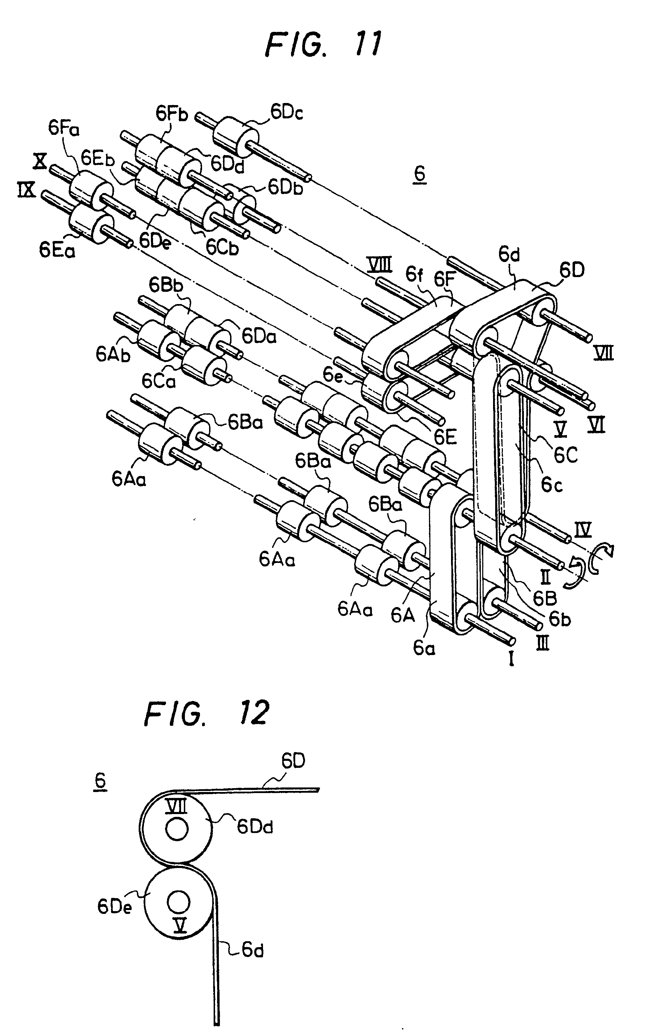

The film delivery mechanism 6 comprises an upper conveyor belt mechanism above and a lower conveyor belt mechanism below the path of the panels 1. The upper conveyor belt mechanism which Fig. 11 shows in detail consists of fixed conveyor belt units 6A, 6C, 6D, 6E and 6F and a displaceable conveyor belt unit 6B.

The fixed conveyor belt unit 6A consists of a roller 6Aa supported by a driven shaft I, a roller 6Ab supported by a driving shaft II and a belt 6a wound around the rollers 6Aa and 6Ab. The displaceable conveyor belt unit 6B consists of a roller 6Ba supported by a driven shaft III, a roller 6Bb supported by a driving shaft IV and a belt 6b wound around the rollers 6Ba and 6Bb. The conveyor belt unit 6B can be rotated around the driving shaft IV in the direction of arrow L as shown in Fig. 5. It facilitates adhesion of the peeled film 1d to the peeling plate 5 and is capable of carrying the film 1d by sandwiching it between the conveyor belt units 6B and 6A. Sandwiching the film 1d between the conveyor belt units 6A and 6B is effected through cuts 5A provided in the peeling plate 5, as shown in Fig. 10.

The conveyor belt unit 6C consists of a roller 6Ca supported by the driving shaft II, a roller 6Cb supporter by a driven shaft V and a belt 6c wound around the rollers 6Ca and 6Cb. The conveyor belt unit 6D consists of a roller 6Da supported by the driving shaft IV, a roller 6Db supported by a driven shaft VI, a roller 6Dc supported by a driven shaft VII, a roller 6Dd supported by a driven shaft VIII, a roller 6De supported by the driven shaft V and a belt 6d wound around the rollers 6Da to 6De.

The fixed conveyor belt units 6C and 6D further carry out the film 1d delivered by the conveyor belt units 6A and 6B. The conveyor belt unit 6E consists of a roller 6Ea supported by a driven shaft IX, a roller 6Eb supported by the driven shaft V and a belt 6e wound around the rollers 6Ea and 6Eb. The conveyor belt unit 6F consists of a roller 6Fa supported by a driven shaft X, a roller 6Fb supported by the driven shaft VIII and a belt 6f wound around the rollers 6Fa and 6Fb.

As shown in Figs. 4 and 5, the conveyor belt units 6E and 6F are so arranged as to discharge the films 1d carried by the conveyor belt units 6C and 6D from the apparatus body in the direction of a arrow M into a container 7A for receiving the peeled upper films 1d discharged, as shown in Fig. 4.

The lower conveyor belt mechanism comprises a fixed conveyor belt unit 6G and a displaceable conveyor belt unit 6H as shown in Fig. 5. The conveyor belt unit 6G consists of rollers 6Ga, 6Gb and 6Gc supported by respective shafts (not shown), and a belt 6g wound around the rollers 6Ga to 6Gc. The conveyor belt unit 6H consists of rollers 6Ha, 6Hb and 6Hc supported by respective shafts (not shown), and a belt 6h wound around the rollers 6Ha, to 6Hc.

The conveyor belt units 6G and 6H carry the films 1d peeled from the lower side of the panels 1 with the help of a peeling plate 5 as in the case of the above-described upper conveyor belt mechanism. The conveyor belt units 6G and 6H discharge the peeled films 1d from the apparatus body in the direction of arrow 0 into a containers 7B as shown in Fig. 4. The container 7A and 7B are both detachably mounted on the apparatus body. Roll-in preventing members 9 are installed close to the conveyance path at the discharge to prevent the films 1d from being wound around the conveyor belt units 6E and 6F or 6G and 6H.

Also, as shown in Fig. 5, static eliminators 10 and ion dispersion devices 11 may be installed close to the conveyor belt units 6A and 6H.

The static eliminators 10 and the ion dispersion devices 11 both serve to reduce the static electrification of the films 1d adopted while these are peeled off or delivered.

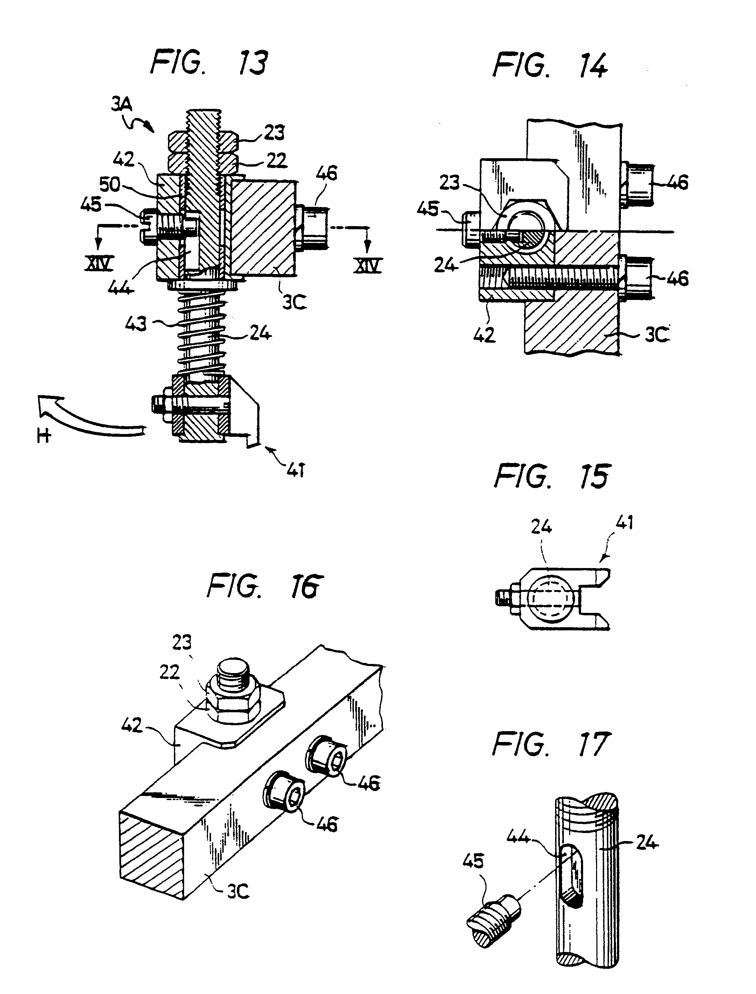

According to a third embodiment of the present invention the press device 3A may also be constructed as shown in Fig. 13 through 17. In this case the press member 24 has two finger portions 41 for raising the leading end of the film 1D from the panel. The press member 24 is slidably supported by a holding member 42 through a bearing 50 and biased by a spring 43. The holding member 42 is fixedly secured to the support shaft 3C by two screws 46. Two nuts 22 and 23 are in this case threaded directly on the press member 24 at its upper portion.

The press member 24 has a key slot 44 for receiving a key screw 45 provided in the holding member 42.

The size of the key slot 44 is selected such that the press member 24 can slide in its axial direction but cannot rotate relative to the holding member 42.

When the support shaft 3C is rotated in direction of arrow H shown in Fig. 13 the press member 24 is also moved in the direction of arrow H, so that the finger portions 41 press and raise the end portion of the film 1D on the panel 1. Since, the press member 24 has two finger portions 41 for raising the end portion of the film 1D, the film raising operation is improved. Namely, if one of the finger portions 41 tends to enter into a positioning hole of the panel, the other finger portion prevents it from doing so, so that the film end will still be raised to thereby initiate peeling.

## Claims

1. A film raising device for raising a film laminated on a panel (1) which film is then to be peeled off from said panel, such as a protective film (1D), the device including rotating means applying a force to said film and being characterized by
   - a rotable support shaft (3C) extending substantially in parallel to a leading end of said film (1D),
   - at least one elongated press member (24) slidably supported by said support shaft (3C) in the longitudinal direction of said press member and by rotation of said support shaft, transversally with respect to the shaft axis, said press member having a pointed end projecting sufficiently from said support shaft to engage said panel (1), when said support shaft is rotated,
   - spring means (21, 25; 43) biasing said press member (24) with respect to said support shaft (3C) in the direction of the pointed end of said press member, and
   - drive means (3F, 3G, 3H) for rotating said support shaft (3C).

2. The film raising device of claim 1 wherein said pointed end of said press member (24) consists of an integral cone formed to said press member.

3. The film raising device of claim 1 wherein said pointed end of said press member (24) consists of at least one finger portion (41) provided on said press member.

4. The film raising device of anyone of the preceding claims wherein means (44, 45) are provided to prevent said press member (24) from rotation around its longitudinal axis.

5. The film raising device of anyone of the preceding claims wherein the extent of the projection of said press member (24) and/or the biasing force acting on said press member is adjustable.

6. The film raising device of anyone of the preceding claims, further comprising a cylindrical support member (20) surrounding and slidably receiving said press member (24), said support member being slidably supported in its longitudinal direction by said support shaft (3C), said spring means comprising a first spring (21) biasing said support member (20) with respect to said support shaft and a second spring (25) biasing said press member with respect to said support member, both springs acting in the direction of the pointed end of said press member.

7. The film raising device of claim 6 wherein said support member (20), at its end closer to the pointed end of said press member (24), has a head (20B) provided with a rounded face.

8. The film raising device of claim 6 or 7 wherein the extent of a projection of said support member (20) and/or the biasing force acting on said support member is adjustable.

9. The film raising device of anyone of the preceding claims wherein said drive means (3F, 3G, 3H) is designed to alternatively rotate said support shaft (3C) forwardly and backwardly through a limited angle.

10. The film raising device of anyone of the preceding claims, further comprising second drive means (3K, 3L, 3M) for moving said support shaft (3C) towards and away from said panel.

## Patentansprüche

1. Filmanhebevorrichtung zum Anheben eines auf eine Platte (1) auflamminierten Films, der daraufhin von der Platte abzuziehen ist, wie z.B. eines Schutzfilms (1D), wobei die Vorrichtung eine Kraft auf den Film aufbringende rotierende Mittel aufweist und **gekennzeichnet** ist durch

- eine sich im wesentlichen parallel zu einem Führungsende des Films (1D) erstreckende drehbare Trägerwelle (3C),
- zumindest ein in seiner Längsrichtung und, durch Drehung der Trägerwelle (3C), quer zu der Wellenachse gleitfähig auf der Trägerwelle gelagertes und langgestrecktes Pressglied (24), welches ein hinreichend weit von der Trägerwelle abstehendes spitzes Ende aufweist, um bei Drehung der Trägerwelle mit der Platte (1) in Eingriff zu treten,
- Federmittel (21, 25; 43), welche das Pressglied (24) gegenüber der Trägerwelle (3C) in Richtung seines spitzen Endes drücken, und
- Antriebsmittel (3F, 3G, 3H) zum Drehen der Trägerwelle (3C).

2. Filmanhebevorrichtung nach Anspruch 1, worin das spitze Ende des Pressgliedes (24) aus einem an das Pressglied angeformten integralen Konus besteht.

3. Filmanhebevorrichtung nach Anspruch 1, worin das spitze Ende des Pressgliedes (24) aus zumindest einem an dem Pressglied vorgesehenen Fingerabschnitt (41) besteht.

4. Filmanhebevorrichtung nach irgendeinem der vorhergehenden Ansprüche, worin Mittel (44, 45) vorgesehen sind, um das Pressglied (24) an einer Drehung um seine Längsachse zu hindern.

5. Filmanhebevorrichtung nach irgendeinem der vorhergehenden Ansprüche, worin das Ausmaß des Hervortretens des Pressgliedes (24) und/oder die auf das Pressglied einwirkende Federkraft einstellbar ist.

6. Filmanhebevorrichtung nach irgendeinem der vorhergehenden Ansprüche, des weiteren aufweisend ein das Pressglied (24) umgebendes und gleitfähig aufnehmendes zylindrisches Tragglied (20), das von der Trägerwelle (3C) in seiner Längsrichtung gleitfähig getragen wird, wobei die Federmittel eine das Tragglied (20) gegenüber der Trägerwelle abfedernde erste Feder (21) und eine das Pressglied gegenüber dem Tragglied abfedernde zweite Feder (25) aufweisen und beide Federn in Richtung des spitzen Endes des Pressgliedes wirken.

7. Filmanhebevorrichtung nach Anspruch 6, worin das Tragglied (20) an seinem dem spitzen Ende des Pressgliedes (24) näherliegenden Ende einen Kopf (20B) mit einer gerundeten Stirnfläche aufweist.

8. Filmanhebevorrichtung nach Anspruch 6 oder 7, worin das Ausmaß des Hervortretens des Traggliedes (20) und/oder die auf das Tragglied einwirkende Federkraft einstellbar ist.

9. Filmanhebevorrichtung nach irgendeinem der vorhergehenden Ansprüche, worin die Antriebsmittel (3F, 3G, 3H) dazu ausgelegt sind, die Trägerwelle (3C) um einen begrenzten Winkel abwechselnd vorwärts und rückwärts zu bewegen.

10. Filmanhebevorrichtung nach irgendeinem der vorhergehenden Ansprüche, des weiteren enthaltend zweite Antriebsmittel (3K, 3L, 3M), um die Trägerwelle (3C) auf die Platte zu und von ihr wegzubewegen.

## Revendications

1. Appareil de soulèvement d'un film collé sur un panneau (1), le film étant alors séparé du panneau par pelage, le film étant par exemple un film protecteur (1D), l'appareil comprenant un dispositif rotatif destiné à appliquer une force au film et étant caractérisé par :

- un arbre rotatif (3C) de support disposé en direction sensiblement parallèle à une extrémité antérieure du film (1D),
- au moins un organe allongé de pressage (24) supporté par l'arbre de support (3C) afin qu'il puisse coulisser dans la direction longitudinale de l'organe de pressage et par rotation de l'arbre de support, transversalement à l'axe de l'arbre, l'organe de pressage ayant une extrémité pointue dépassant suffisamment de l'arbre de support pour qu'elle vienne au contact du panneau (1) lorsque l'arbre de support tourne,
– un dispositif élastique (21, 25 ; 43) rappelant l'organe de pressage (24) par rapport à l'arbre de support (3C) dans le sens de l'extrémité pointue de l'organe de pressage, et
– un dispositif d'entraînement (3F, 3G, 3H) destiné à faire tourner l'arbre de support (3C).

2. Appareil de soulèvement de film selon la revendication 1, dans lequel l'extrémité pointue de l'organe de pressage (24) constitue un cône solidaire formé sur l'organe de pressage.

3. Appareil de soulèvement de film selon la revendication 1, dans lequel l'extrémité pointue de l'organe de pressage (24) est constituée d'au moins une partie de doigt (41) disposée sur l'organe de pressage.

4. Appareil de soulèvement de film selon l'une quelconque des revendications précédentes, dans lequel un dispositif (44, 45) est destiné à empêcher la rotation de l'organe de pressage (24) autour de son axe longitudinal.

5. Appareil de soulèvement de film selon l'une quelconque des revendications précédentes, dans lequel l'amplitude de déplacement de l'organe de pressage (24) et/ou la force de rappel agissant sur l'organe de pressage est réglable.

6. Appareil de soulèvement de film selon l'une quelconque des revendications précédentes, comprenant en outre un organe cylindrique de support (20) qui entoure l'organe de pressage (24) et le loge de manière qu'il puisse coulisser, l'organe de support étant supporté afin qu'il puisse coulisser dans la direction longitudinale sur l'arbre de support (3C), le dispositif élastique comprenant un premier ressort (21) qui rappelle l'organe de support (20) par rapport à l'arbre de support et un second ressort (25) qui rappelle l'organe de pressage par rapport à l'organe de support, les deux ressorts agissant dans le sens de l'extrémité pointue de l'organe de pressage.

7. Appareil de soulèvement de film selon la revendication 6, dans lequel l'organe de support (20), à son extrémité la plus proche de l'extrémité pointue de l'organe de pressage (24), a une tête (20B) munie d'une face arrondie.

8. Appareil de soulèvement de film selon la revendication 6 ou 7, dans lequel l'amplitude de déplacement de l'organe de support (20) et/ou la force de rappel agissant sur l'organe de support est réglable.

9. Appareil de soulèvement de film selon l'une quelconque des revendications précédentes, dans lequel le dispositif d'entraînement (3F, 3G, 3H) est réalisé afin qu'il fasse tourner en alternance l'arbre de support (3C) vers l'avant et vers l'arrière d'un angle limité.

10. Appareil de soulèvement de film selon l'une quelconque des revendications précédentes, comprenant en outre un second dispositif d'entraînement (3K, 3L, 3M) destiné à déplacer l'arbre de support (3C) vers le panneau et à distance de celui-ci.

FIG. 1

FIG. 2

FIG. 3

## FIG. 4

# FIG. 5

# FIG. 6

FIG. 7

## FIG. 8

## FIG. 9

## FIG 10

## FIG. 11

## FIG. 12

## FIG. 13

## FIG. 14

## FIG. 15

## FIG. 16

## FIG. 17